(19) Europäisches Patentamt
European Patent Office
Office européen des brevets

(11) **EP 4 397 985 B1**

(12) **EUROPÄISCHE PATENTSCHRIFT**

(45) Veröffentlichungstag und Bekanntmachung des Hinweises auf die Patenterteilung:
**16.04.2025 Patentblatt 2025/16**

(21) Anmeldenummer: **23150585.0**

(22) Anmeldetag: **06.01.2023**

(51) Internationale Patentklassifikation (IPC):
**G01R 31/34** (2020.01)   **G01R 31/72** (2020.01)

(52) Gemeinsame Patentklassifikation (CPC):
**G01R 31/72; G01R 31/346;** G01R 31/1272

(54) **VERFAHREN ZUR ERKENNUNG VON SPANNUNGSABHÄNGIGEN FEHLERN IN EINEM ELEKTRISCHEN WICKLUNGSSYSTEM**

METHOD FOR DETECTING VOLTAGE DEPENDENT FAULTS IN AN ELECTRICAL WINDING SYSTEM

PROCÉDÉ DE DÉTECTION DE DÉFAUTS DÉPENDANT DE LA TENSION DANS UN SYSTÈME D'ENROULEMENT ÉLECTRIQUE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(43) Veröffentlichungstag der Anmeldung:
**10.07.2024 Patentblatt 2024/28**

(73) Patentinhaber: **Schleich GmbH**
**58675 Hemer (DE)**

(72) Erfinder:
• **LAHRMANN, Jan-Philipp**
**58675 Hemer (DE)**
• **KOCH, Stefan**
**58809 Neuenrade (DE)**

(74) Vertreter: **Schäperklaus, Jochen**
**Fritz Patent- und Rechtsanwälte**
**Partnerschaft mbB**
**Postfach 1580**
**59705 Arnsberg (DE)**

(56) Entgegenhaltungen:
**EP-A1- 2 402 775     EP-A1- 4 001 935**
**EP-B1- 0 461 191     JP-A- 2007 108 058**

EP 4 397 985 B1

**Beschreibung**

Die vorliegende Erfindung betrifft ein Verfahren zur Erkennung von spannungsabhängigen Fehlern in einem elektrischen Wicklungssystem gemäß dem Oberbegriff des Anspruchs 1 und eine Vorrichtung.

Aus dem Stand der Technik sind solche Verfahren bekannt; ein relevantes Dokument aus dem Stand der Technik ist JP 2007 108058 A. Sie werden eingesetzt, um bei elektrischen Wicklungssystemen, wie beispielsweise Elektromotoren oder Generatoren, Windungsschlüsse und Isolationsfehler innerhalb einer elektrischen Wicklung zu detektieren. Zu diesem Zweck wird beispielsweise ein geladener Kondensator relativ schnell parallel zu der zu prüfenden elektrischen Wicklung entladen. Dies erzeugt für eine relativ kurze Zeit eine relativ hohe Spannung in der elektrischen Wicklung, dem so genannten Stoßspannungsimpuls. Die im Kondensator gespeicherte Energie entlädt sich in die Induktivität. Die dann in der Induktivität gespeicherte Energie entlädt sich wieder in den Kondensator. Aufgrund von Dämpfungsverlusten ist dieser Vorgang an den Anschlüssen der elektrischen Wicklung als gedämpfte Schwingung zu messen. Aus dem gemessenen Spannungsverlauf können Rückschlüsse auf die Qualität der elektrischen Wicklung und dem Isoliersystem gezogen werden. Bei einer intakten Wicklung hat der Spannungsverlauf eine typische Frequenz und einen charakteristischen Amplitudenverlauf. Der Spannungsverlauf eines intakten elektrischen Wicklungssystems wird als Referenz genommen und mit einem zu prüfenden Wicklungssystem verglichen. Im Falle von Abweichungen, die außerhalb von festgelegten Grenzwerten liegen, kann die elektrische Wicklung als fehlerhaft detektiert werden.

Bei dem Vergleich zwischen Referenzwicklung und zu prüfender Wicklung kann kein 100% gleiches Ergebnis erwartet werden, da aufgrund von Fertigungstoleranzen kleine Unterschiede zwischen den Wicklungen entstehen. Es kann daher nicht immer mit Sicherheit möglich sein eine Abweichung zwischen der Referenzwicklung und der zu prüfenden Wicklung auf die richtige Ursache zurückzuführen und eindeutig zu unterscheiden, ob eine Fertigungstoleranz oder ein kleiner spannungsabhängiger Fehler vorliegt.

Um sehr kleine spannungsabhängige Fehler zu detektieren, ist es bekannt, eine zu prüfende Wicklung für sich selbst als Referenz zu nutzen. Dabei wird die Prüfung mit einem Stoßspannungsimpuls mit einem kleinen Spitzenwert der Spannung gestartet, bei der der spannungsabhängige Fehler noch nicht auftritt. Nun wird der Spitzenwert der Spannung schrittweise an der zu prüfenden Wicklung erhöht. Der gemessene Spannungsverlauf wird jeweils mit dem zuvor gemessenen Spannungsverlauf verglichen. Bei diesem Verfahren wird die prozentuale Änderung bei gleicher Spannungsschrittweite bei höheren Spitzenwerten der Spannung kleiner, was wiederum dazu führen kann, dass kleine spannungsabhängige Fehler nicht erkannt werden. Das Ganze kann kompensiert werden, indem die Spannungserhöhung pro Schritt verkleinert wird. Dies kann jedoch zu einer relativ langen Dauer der Prüfung führen.

An diesem Punkt setzt die Erfindung an.

Es ist die Aufgabe der vorliegenden Erfindung ein Verfahren vorzuschlagen, bei dem spannungsabhängige Fehler, insbesondere kleine spannungsabhängige Fehler in einem elektrischen Wicklungssystem erkannt werden.

Die Aufgabe wird durch ein Verfahen gemäß Anspruch 1 und durch eine Vorrichtung gemäß Anspruch 15 gelöst.

Das Verfahren zur Erkennung von spannungsabhängigen Fehlern in einem elektrischen Wicklungssystem, umfasst zumindest die nachfolgenden Schritte:

-   Abgabe von mindestens zwei Stoßspannungsimpulsen an das elektrische Wicklungssystem, wobei jeder Stoßspannungsimpuls einen anderen Spitzenwert $U_t$ aufweist,
-   Messung von Spannungsverläufen am Wicklungssystem nach der Abgabe jeweils eines Stoßspannungsimpulses, wobei die Spannungsverläufe jeweils eine gedämpfte Schwingung umfassen, wobei jeder Spannungsverlauf jeweils durch einen der Stoßspannungsimpulse verursacht wird,
-   Speicherung der Spannungsverläufe, wobei
-   ein erster Spannungsverlauf, der durch einen ersten der Stoßspannungsimpulse verursacht wird, als Referenz genutzt wird, um einen berechneten zweiten Spannungsverlauf, der durch einen zweiten der Stoßspannungsimpulse verursacht wird, zu berechnen,
-   der berechnete zweite Spannungsverlauf und der gemessene zweite Spannungsverlauf miteinander verglichen werden,
-   bei einem Unterschied zwischen dem berechneten und dem gemessenen zweiten Spannungsverlauf oberhalb eines Grenzwertes ein spannungsabhängiger Fehler in dem elektrischen Wicklungssystem erkannt wird.

Der erste gemessene Spannungsverlauf, der durch den ersten Stoßspannungsimpuls verursacht wird, wird dazu genutzt einen berechneten zweiten Spannungsverlauf zu berechnen. Der gemessene zweite Spannungsverlauf, der durch den zweiten Stoßspannungsimpuls, mit einem anderen Spitzenwert als bei dem ersten Stoßspannungsimpuls, verursacht wird, wird mit dem berechneten Spannungsverlauf verglichen. Liegt der Unterschied zwischen den beiden Spannungsverläufen oberhalb eines Grenzwertes, kann ein spannungsabhängiger Fehler erkannt werden.

Vorteilhafterweise werden die Spannungsverläufe über zumindest zwei elektrische Kontakte des Wicklungssystems gemessen.

Die Besonderheit des vorliegenden Verfahrens liegt darin, dass der gemessene zweite Spannungsverlauf mit einem berechneten zweiten Spannungsverlauf verglichen wird. Ausgehend von einem ersten gemessenen Spannungsverlauf wird das Ergebnis der Messung, welches auf den zweiten Stoßspannungsimpuls folgt, vorher berechnet und zum Vergleich genutzt.

Dabei kann es vorgesehen sein, dass der Spitzenwert des zweiten Stoßspannungsimpulses durch den Spitzenwert des ersten Stoßspannungsimpulses plus eine Spannungserhöhung gebildet wird. Der erste Stoßspannungsimpuls beginnt mit einem Spitzenwert der ausreichend klein ist, dass der spannungsabhängige Fehler nicht auftritt. Der Spitzenwert des zweiten Stoßspannungsimpulses ist daher vorteilhafterweise größer als der Spitzenwert des ersten Stoßspannungsimpulses.

Weiterhin kann es vorgesehen sein, dass der berechnete zweite Spannungsverlauf aus dem ersten Spannungsverlauf multipliziert mit einem Skalierungskfaktor berechnet wird. Hierbei wird für den Bereich zwischen erstem Stoßspannungsimpuls und zweiten Stoßspannungsimpuls ein lineares Verhalten des elektrischen Wicklungssystems unterstellt. Jeder Spannungswert des ersten Spannungsverlaufes wird mit einem Skalierungsfaktor multipliziert. Der Skalierungsfaktor kann beispielsweise aus den Spitzenwerten der beiden Stoßspannungsimpulse berechnet werden.

Zur sicheren Erkennung eines spannungsabhängigen Fehlers in einem elektrischen Wickungssystem ist es häufig nicht ausreichend zwei Stoßspannungsimpulse an das elektrische Wicklungssystem abzugeben. Daher kann es vorgesehen sein, dass n Stoßspannungsimpulse an das elektrische Wicklungssystem abgegeben werden, wobei jeder der n Stoßspannungsimpulse einen anderen Spitzenwert $U_{t_m}$ aufweist. Hier kann es vorgesehen sein, dass der Spitzenwert des m. Stoßspannungsimpulses durch den Spitzenwert des m-1. Stoßspannungsimpulses plus eine Spannungserhöhung gebildet wird. Die Spannungserhöhung kann dabei jeweils einen konstanten Wert haben oder aber von Spannungsimpuls zu Spannungsimpuls größer oder kleiner werden. Hier ist es ebenfalls möglich, dass die Spannungserhöhung einer nichtlinearen Funktion folgt.

Es besteht die Möglichkeit, dass der berechnete m. Spannungsverlauf berechnet wird nach der Formel

$$Spannungsverlauf\,_{m_{berechnet}} = Spannungsverlauf_{m-1_{gemessen}} * f$$

wobei *Spannungsverlauf $_{m_{berechnet}}$* der berechnete Spannungsverlauf des m. Stoßspannungsimpulses ist, wobei *Spannungsverlauf$_{m-1_{gemessen}}$* der gemessene Spannungsverlauf des m-1. Stoßspannungsimpulses ist, wobei *f* der Skalierungsfaktor ist und wobei $2 \leq m \leq n$.

Für alle Spannungsverläufe, die von dem zweiten bis zum n. Stoßspannungsimpuls verursacht werden, wird ein berechneter m. Spannungsverlauf berechnet.

Dabei kann es vorgesehen sein, dass der Skalierungsfaktor berechnet wird als $f = U_{t_m} \big/ U_{t_{m-1}}$, wobei $U_{t_m}$ der Spitzenwert des m. Stoßspannungsimpulses ist und $U_{t_{m-1}}$ der Spitzenwert des m-1. Stoßspannungsimpulses. Der Skalierungsfaktor wird damit immer in Abhängigkeit der Spannungserhöhung zwischen zwei Stoßspannungsimpulsen berechnet. Für den Fall, dass die Spannungserhöhung zwischen den einzelnen Stoßspannungsimpulsen keinen konstanten Wert hat, ist durch die Berechnung des Skalierungsfaktors in Abhängigkeit der Spannungserhöhung sichergestellt, dass die unterschiedlichen Spannungserhöhungen sich in dem Skalierungsfaktor niederschlagen. Dadurch wird die Genauigkeit der Berechnung des Spannungsverlaufes erhöht.

Dieser berechnete m. Spannungsverlauf wird mit dem gemessenen m. Spannungsverlauf verglichen und der Unterschied wird festgestellt. Hierbei kann es vorgesehen sein, dass zum Vergleich des berechneten und des gemessenen m. Spannungsverlaufs eine Referenzfläche als Integral des berechneten m. Spannungsverlaufs berechnet wird, eine Fläche als Integral des gemessenen m. Spannungsverlaufs berechnet wird und eine Differenzfläche als Differenz von Referenzfläche und Fläche berechnet wird, wobei die Differenzfläche den Unterschied zwischen dem berechneten und dem gemessen m. Spannungsverlauf darstellt. Da die Spannungswerte jedes Spannungsverlaufs sowohl positive als auch negative Werte annehmen und sich daher sowohl positive als auch negative Teilflächen ergeben, kann die Bestimmung der Referenzfläche und der Fläche im vereinfachten Fall durch Addieren der einzelnen Teilflächen als Betrag ohne Vorzeichen erfolgen.

Für einen besseren Vergleich der einzelnen Differenzflächen ist es vorteilhaft, einen prozentualen Wert zu vergleichen. Daher kann es vorgesehen sein, dass eine Berechnung eines Fehlerflächenverhältnisses aus der Differenzfläche und der Referenzfläche gemäß der Formel

$$EAR_m = \frac{\left|A_{diff}\right| * 100\%}{\left|A_{ref}\right|}$$

erfolgt, wobei $A_{ref}$ die Referenzfläche ist, $A_m$ die Fläche ist und $A_{diff}$ die Differenzfläche ist. Die Besonderheit des Fehlerflächenverhältnisses ist, dass die Berechnung der Differenzfläche aufgrund des berechneten m. Spannungsverlaufes im Vergleich zum gemessenen m. Spannungsverlauf erfolgt.

Ebenfalls kann es vorgesehen sein, dass ein erwartetes Fehlerflächenverhältnis berechnet wird, wobei das erwartete Fehlerflächenverhältnis von dem berechneten Fehlerflächenverhältnis $EAR_m$ abgezogen wird und ein Vergleich der Differenz aus erwartetem Fehlerflächenverhältnis und berechnetem Fehlerflächenverhältnis mit dem Grenzwert erfolgt. Bei einem optimal gefertigten Wicklungssystem würden die Differenz 0% ergeben. Für das erwartete Fehlerflächenverhaltnis wird zunächst das Fehlerflächenverhältnis der ersten beiden gemessenen Spannungsverläufe berechnet und auf den darauf folgenden Spannungsverlauf, der durch einen Stoßspannungsimpuls mit einem höheren Spitzenwert der Spannung erfolgt extrapoliert. Hierbei ist zu beachten, die berechnete Referenzfläche und die Fläche bei einer Erhöhung des Spitzenwertes der Spannung kleiner werden, da die prozentuale Abweichung zwischen den Spitzenwerten der einzelnen Stoßspannunsimpulse sich verringert.

Es kann vorgesehen sein, dass für jeden der m berechneten und gemessenen Spannungsverläufe ein Fehlerflächenverhältnis berechnet wird. Werden alle Differenzen der erwarteten Fehlerflächenverhältnisse und der berechneten Fehlerflächenverhältnisse der m Spannungsverläufe miteinander verglichen, schwanken die Differenzen bei einem intakten Wicklungssystem ohne spannungsabhängigen Fehler in einem engen Bereich um 0%, vorteilhafterweise zwischen -5% und +5%. Liegt der Betrag des Fehlerflächenverhältnisses oberhalb eines Grenzwertes, vorteilhafterweise oberhalb von 15% wird ein spannungsabhängiger Fehler erkannt. In einem solchen Fall werden keine weiteren Stoßspannungsimpulse an das Wicklungssystem angeben.

Weiterhin kann es vorgesehen sein, dass jedes Fehlerflächenverhältnis, dass aus den m berechneten und gemessenen Spannungsverläufen berechnet wird, normiert wird. Hierzu kann es vorgesehen sein, dass die Fehlerflächenverhältnisse mittels eines Normierungsfaktors normiert werden. Werden alle normierten Fehlerflächenverhältnisse der m Spannungsverläufe miteinander verglichen, schwanken die normierten Fehlerflächenverhältnisse bei einem intakten Wicklungssystem ohne spannungsabhängigen Fehler in einem engen Bereich um 1 %, vorteilhafterweise zwischen -2% und +4%. Liegt der Betrag des normierten Fehlerflächenverhältnisses oberhalb eines Grenzwertes, insbesondere oberhalb von 5% wird ein spannungsabhängiger Fehler erkannt. In einem solchen Fall werden keine weiteren Stoßspannungsimpulse an das Wicklungssystem angeben.

Es kann vorgesehen sein, dass der Normierungsfaktor gemäß der Formel $\frac{U_{t_{m-1}}}{(U_{t_m} - U_{t_{m-1}}) * 100}$ berechnet wird, wobei $U_{t_m}$ der Spitzenwert des m. Stoßspannungsimpulses ist und $U_{t_{m-1}}$ der Spitzenwert des m-1. Stoßspannungsimpulses ist. Der Normierungsfaktor wird damit immer in Abhängigkeit der Spitzenwerte der Stoßspannungsimpulse und damit mittelbar in Abhängigkeit der Spannungserhöhung zwischen zwei Stoßspannungsimpulsen berechnet. Für den Fall, dass die Spannungserhöhung zwischen den einzelnen Stoßspannungsimpulsen keinen konstanten Wert hat, ist durch die Berechnung des Normierungsfaktors in Abhängigkeit der Spannungserhöhung sichergestellt, dass die unterschiedlichen Spannungserhöhungen sich in dem Normierungsfaktor niederschlagen.

Es besteht weiterhin die Möglichkeit, dass eine Referenzfläche als Integral des gemessenen ersten Spannungsverlaufs berechnet wird, eine Fläche als Integral des gemessenen zweiten Spannungsverlaufs berechnet wird, eine Differenzfläche als Differenz von Referenzfläche und Fläche berechnet wird, wobei die Differenzfläche den Unterschied zwischen dem gemessenen ersten und dem gemessen zweiten Spannungsverlauf darstellt, eine Berechnung eines Fehlerflächenverhältnisses aus der Differenzfläche und der Referenzfläche gemäß der Formel

$$EAR_2 = \frac{\left| A_{diff_2} \right| * 100\%}{\left| A_{ref_2} \right|}$$

erfolgt, wobei $A_{ref_2}$ die Referenzfläche des gemessenen ersten Spannungsverlaufs ist und $A_{diff_2}$ die Differenzfläche ist, die den Unterschied zwischen dem gemessenen ersten und dem gemessen zweiten Spannungsverlauf darstellt, das Fehlerflächenverhältnis mit einem oberen und einem unteren Grenzwert verglichen wird und bei einem Überschreiten des oberen Grenzwertes oder bei einem Unterschreiten des unteren Grenzwertes ein spannungsabhängiger Fehler in dem elektrischen Wicklungssystem erkannt wird.

Für alle m Spannungsverläufe kann es vorgesehen sein, dass der Unterschied des gemessenen m. Spannungsverlaufs und des gemessenen m-1. Spannungsverlauf berechnet wird, wobei $2 \leq m \leq n$, n-1 obere Grenzwerte festgelegt werden und n-1 untere Grenzwerte festgelegt werden, wobei jeweils ein oberer und ein unterer Grenzwert jeweils einem der Unterschiede zugeordnet werden, wobei sich die Grenzwerte aus dem Mittelwert der Unterschiede zuzüglich und abzüglich einer zugelassenen Abweichung berechnen. Die zugelassene Abweichung ist je nach Anwendungfall unterschiedlich. Die zugelassene Abweichung kann zwischen 5% und 15% liegen. Bei einem Unterschreiten einer der Unterschiede unter den zugehörigen unteren Grenzwert oder bei einem Überschreiten einer der Unterschiede über den zugehörigen oberen Grenzwertes ein spannungsabhängiger Fehler in dem elektrischen Wicklungssystem erkannt wird. Es ist vorstellbar, dass der Unterschied zwischen gemessenen m. Spannungsverlauf und dem gemessenen m-1. Spannungsverlauf durch die Berechnung von m Fehlerflächenverhältnissen festgestellt wird. Zu jeden Fehlerflächenverhältnis kann dann ein oberer und ein unterer Grenzwert festgelegt werden. Werden die Fehlerflächenverhältnisse und die oberen und unteren Grenzwerte beispielsweise in einem Diagramm aufgetragen, ergibt sich eine Art Hüllkurve aus oberen Grenzwerten und eine Hüllkurve aus unteren Grenzwerten, die die Fehlerflächenverhältnisse einschließen. Tritt eine Fehlerflächenverhältnis aus dieser Hüllkurve heraus, wird ein spannungsabhängiger Fehler festgestellt.

Eine Vorrichtung zur Erkennung von spannungsabhängigen Fehlern in einem elektrischen Wicklungssystem, umfasst zumindest eine Mittel zur Erzeugung eines Stoßspannungsimpulses, Anschlüsse für eine elektrische Verbindung der Vorrichtung mit dem elektrischen Wicklungssystem, ein Speichermittel, wobei das Speichermittel dazu ausgebildet ist, Messdaten der Spannungsverläufe zu empfangen, zu speichern und bereitzustellten, ein Auswertemittel, wobei das Auswertemittel dazu ausgebildet ist, die von dem Speichermittel bereitgestellten Messdaten der Spannungsverläufe zu vergleichen und mit den bereitgestellten Messdaten der Spannungsverläufe Hilfsgrößen zu berechnen, wobei die Vorrichtung dazu ausgebildet ist, ein erfindungsgemäßes Verfahren auszuführen.

Weitere Merkmale und Vorteile von Ausführungsbeispielen der Erfindung werden unter Bezugnahme auf die Zeichnungen nachfolgend beschrieben. Dabei werden für gleiche oder ähnliche Teile und für Teile mit gleichen oder ähnlichen Funktionen dieselben Bezugszeichen verwendet. Es zeigt:

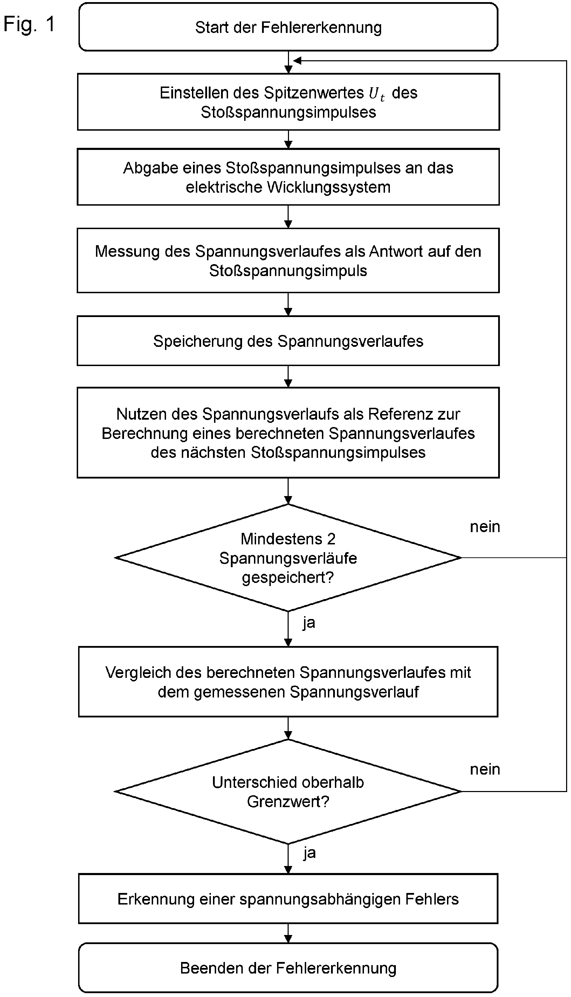

Fig. 1    ein Ablaufdiagramm eines erfindungsgemäßen Verfahrens

Es ist nicht notwendig, dass ein erfindungsgemäßes Verfahren alle nachfolgend beschriebenen Merkmale aufweist. Es ist auch möglich, dass ein erfindungsgemäßes Verfahren nur einzelne Merkmale des nachfolgend beschriebenen Ausführungsbeispiels aufweist.

Fig. 1 zeigt ein Ablaufdiagramm zur Veranschaulichung der Erkennung von spannungsabhängigen Fehlern in einem elektrischen Wicklungssystem gemäß der vorliegenden Erfindung.

Zunächst wird die Fehlererkennung gestartet. Hierzu wird ein Spitzenwert eines Stoßspannungsimpulses eingestellt. Der Spitzenwert des Stoßspannungsimpulses ist abhängig von dem zu prüfenden elektrischen Wicklungssystem und so zu wählen, dass sichergestellt ist, dass kein spannungsabhängiger Fehler in dem elektrischen Wicklungssystem auftritt.

Der durch den Spitzenwert näher definierte Stoßspannungsimpuls wird an das elektrische Wicklungssystem abgegeben. Hierbei kann beispielsweise so vorgegangen werden, dass ein geladener Kondensator relativ schnell parallel zu der zu prüfenden Wicklung geschaltet wird. Dies erzeugt für eine relativ kurze Zeit eine relativ hohe Spannung in der Wicklung, dem so genannten Stoßspannungsimpuls. Der Stoßspannungsimpuls hat einen einstellbaren Spitzenwert. Die im Kondensator gespeicherte Energie entlädt sich in die Induktivität. Die dann in der Induktivität gespeicherte Energie entlädt sich wieder in den Kondensator. Als Antwort auf den Stoßspannungsimpuls wird eine gedämpfte Schwingung erzeugt, die als Spannungsverlauf an elektrischen Kontakten des elektrischen Wicklungssystems gemessen wird.

Der gemessene Spannungsverlauf wird gespeichert. Hierzu kann ein Speichermittel vorhanden sein, das dazu ausgebildet ist, Messdaten der Spannungsverläufe zu empfangen, zu speichern und bereitzustellten. Der gemessene Spannungsverlauf wird genutzt, um einen berechneten Spannungsverlauf eines weiteren Stoßspannungsimpulses zu berechnen. Für die Berechnung des berechneten Spannungsverlauf werden nach dem Ausführungsbeispiel der Erfindung die gemessenen Spannungswerte des gemessenen Spannungsverlaufs mit einem Skalierungsfaktor multipliziert.

Dann wird geprüft, ob mindestens zwei gemessene Spannungsverläufe in dem Speichermittel gespeichert wurden. Wird die Abfrage mit nein beantwortet, beginnt das Ablaufdiagramm erneut mit der Einstellung eines Spitzenwertes für den Stoßspannungsimpuls. Dieser Spitzenwert unterscheidet sich von dem vorherigen Spitzenwert durch eine Spannungserhöhung. Die Spannungserhöhung ist je nach zu prüfendem elektrischen Wicklungssystem unterschiedlich und individuell festzulegen.

Nach der Abgabe des zweiten Stoßspannungsimpulses wird der Spannungsverlauf, der durch den Stoßspannungsverlauf verursacht wurde, gemessen und in dem Speichermittel gespeichert.

Der gemessene zweite Verlauf wird ebenfalls als Referenz zur Berechnung eines berechneten Spannungsverlaufs des nächsten Stoßspannungsimpulses genutzt.

Der gemessene zweite Spannungsverlauf wird mit dem berechneten zweiten Spannungsverlauf verglichen und der Unterschied zwischen den beiden Spannungsverläufen wird festgestellt. Dies kann in einem Auswertemittel erfolgen, das dazu ausgebildet ist, die von dem Speichermittel bereitgestellten Messdaten der Spannungsverläufe zu vergleichen und mit den bereitgestellten Messdaten der Spannungsverläufe Hilfsgrößen zu berechnen. Die berechneten Hilfsgrößen können beispielsweise das Fehlerflächenverhältnis zwischen den beiden zu vergleichenden Spannungsverläufen sein. Das berechnete Fehlerflächenverhältnis kann wiederum mit einem erwarteten Fehlerflächenverhältnis verglichen werden. Ebenso ist es möglich als Hilfsgröße ein normiertes Fehlerflächenverhältnis zu berechnen. Es sind unterschiedlichste Methoden vorstellbar, den berechneten und den gemessenen Spannungsverlauf miteinander zu vergleichen. Ziel hierbei ist es jeweils den Unterschied zwischen den beiden Spannungsverläufen festzustellen.

Liegt der Betrag des Unterschiedes oberhalb eines festgelegten Grenzwertes, wobei der Grenzwert je nach Art des zu prüfenden elektrischen Wicklungssystems unterschiedlich sein kann, wird ein spannungsabhängiger Fehler erkannt und die Fehlererkennung beendet.

Liegt der Betrag des Unterschiedes unterhalb dieses festgelegten Grenzwertes, beginnt der Ablauf erneut mit dem Einstellen eines Spitzenwertes für einen weiteren Stoßspannungsimpuls. In diesem Fall wäre es der dritte Stoßspannungsimpuls. Der auf die Abgabe des dritten Stoßspannungsimpulses gemessene dritte Spannungsverlauf würde dann gespeichert und für die Berechnung eines berechneten vierten Spannungsverlaufes genutzt. Der gemessene dritte Spannungsverlauf selbst wird mit dem berechneten dritten Spannungsverlauf, der bei dem vorherigen Ablauf berechnet wurde, verglichen. Auch hier wird geprüft, ob der Unterschied zwischen dem berechneten dritten Spannungsverlauf und dem gemessenen dritten Spannungsverlauf oberhalb eines festgelegten Grenzwertes liegt. Ist dies der Fall, wird ein spannungsabhängiger Fehler erkannt und die Fehlererkennung abgebrochen. Ist dies nicht der Fall, beginnt der Ablauf erneut.

Es versteht sich ohne Weiteres, dass nach einer endlichen Anzahl von Stoßspannungsimpulsen die Fehlererkennung beendet wird. Lag in keinem der Durchläufe der Betrag des Unterschiedes oberhalb des festgelegten Grenzwertes, wird das elektrische Wicklungssystem als intakt erkannt.

**Patentansprüche**

1. Verfahren zur Erkennung von spannungsabhängigen Fehlern in einem elektrischen Wicklungssystem, umfassend zumindest die nachfolgenden Schritte:

   - Abgabe von mindestens zwei Stoßspannungsimpulsen an das elektrische Wicklungssystem, wobei jeder Stoßspannungsimpuls einen anderen Spitzenwert $U_t$ aufweist,
   - Messung von Spannungsverläufen am elektrischen Wicklungssystem nach der Abgabe jeweils eines Stoßspannungsimpulses, wobei die Spannungsverläufe jeweils eine gedämpfte Schwingung umfassen, wobei jeder Spannungsverlauf jeweils durch einen der Stoßspannungsimpulse verursacht wurde,
   - Speicherung der Spannungsverläufe,

   **dadurch gekennzeichnet, dass**

   - ein erster Spannungsverlauf, der durch einen ersten der Stoßspannungsimpulse verursacht wird, als Referenz genutzt wird, um einen berechneten zweiten Spannungsverlauf, der durch einen zweiten der Stoßspannungsimpulse verursacht wird, zu berechnen,
   - der berechnete zweite Spannungsverlauf und der gemessene zweite Spannungsverlauf miteinander verglichen werden,
   - bei einem Unterschied zwischen dem berechneten und dem gemessenen zweiten Spannungsverlauf oberhalb eines Grenzwertes ein spannungsabhängiger Fehler in dem elektrischen Wicklungssystem erkannt wird.

2. Verfahren nach Anspruch 1, **dadurch gekennzeichnet, dass** der Spitzenwert des zweiten Stoßspannungsimpulses durch den Spitzenwert des ersten Stoßspannungsimpulses plus eine Spannungserhöhung gebildet wird.

3. Verfahren nach Anspruch 1 oder 2, **dadurch gekennzeichnet, dass** der berechnete zweite Spannungsverlauf aus dem ersten Spannungsverlauf multipliziert mit einem Skalierungsfaktor berechnet wird.

4. Verfahren nach einem der Ansprüche 1 bis 3, **dadurch gekennzeichnet, dass** n Stoßspannungsimpulse an das elektrische Wicklungssystem abgegeben werden, wobei jeder der m Stoßspannungsimpulse einen anderen Spitzen-wert $U_{t_m}$ aufweist.

5. Verfahren nach Anspruch 4, **dadurch gekennzeichnet, dass** der berechnete m. Spannungsverlauf berechnet wird nach der Formel

$$Spannungsverlauf\,_{m_{berechnet}} = Spannungsverlauf_{m-1_{gemessen}} * f$$

wobei *Spannungsverlauf* $_{m_{berechnet}}$ der berechnete Spannungsverlauf des m. Stoßspannungsimpulses ist,

wobei *Spannungsverlauf*$_{m-1_{gemessen}}$ der gemessene Spannungsverlauf des m-1. Stoßspannungsimpulses ist, wobei f der Skalierungsfaktor ist
und wobei $2 \leq m \leq n.$

6. Verfahren nach einem der Ansprüche 4 bis 5, **dadurch gekennzeichnet, dass** der Skalierungsfaktor berechnet wird

als $f = U_{t_m} \Big/ U_{t_{m-1}}$ , wobei $U_{t_m}$ der Spitzenwert des m. Stoßspannungsimpulses ist und $U_{t_{m-1}}$ der Spitzenwert des m-1. Stoßspannungsimpulses.

7. Verfahren nach einem der Ansprüche 4 bis 6, **dadurch gekennzeichnet, dass** zum Vergleich des berechneten und des gemessenen m. Spannungsverlaufs

   - eine Referenzfläche als Integral des berechneten m. Spannungsverlaufs berechnet wird
   - eine Fläche als Integral des gemessenen m. Spannungsverlaufs berechnet wird,
   - eine Differenzfläche als Differenz von Referenzfläche und Fläche berechnet wird, wobei die Differenzfläche den Unterschied zwischen dem berechneten und dem gemessen m. Spannungsverlauf darstellt.

8. Verfahren nach Anspruch 7, **dadurch gekennzeichnet, dass** eine Berechnung eines Fehlerflächenverhältnisses aus der Differenzfläche und der Referenzfläche gemäß der Formel

$$EAR_m = \frac{\left|A_{diff}\right| * 100\%}{\left|A_{ref}\right|}$$

erfolgt, wobei

   $A_{ref}$ die Referenzfläche ist,
   $A_m$ die Fläche ist und
   $A_{diff}$ die Differenzfläche ist.

9. Verfahren nach Anspruch 8, **dadurch gekennzeichnet, dass** ein erwartetes Fehlerflächenverhältnis berechnet wird, wobei das erwartete Fehlerflächenverhältnis von dem berechneten Fehlerflächenverhältnis $EAR_m$ abgezogen wird und ein Vergleich der Differenz aus erwartetem Fehlerflächenverhältnis und berechnetem Fehlerflächenverhältnis mit dem Grenzwert erfolgt.

10. Verfahren nach Anspruch 8, **dadurch gekennzeichnet, dass** für jeden der m berechneten und gemessenen Spannungsverläufe ein Fehlerflächenverhältnis berechnet wird.

11. Verfahren nach Anspruch 10, **dadurch gekennzeichnet, dass** die Fehlerflächenverhältnisse mittels eines Normierungsfaktors normiert werden.

12. Verfahren nach Anspruch 11, **dadurch gekennzeichnet, dass** der Normierungsfaktor gemäß der Formel

$\dfrac{U_{t_{m-1}}}{(U_{t_m} - U_{t_{m-1}}) * 100}$ berechnet wird, wobei $U_{t_m}$ der Spitzenwert des m. Stoßspannungsimpulses ist und $U_{t_{m_{m-1}}}$ der Spitzenwert des m-1. Stoßspannungsimpulses ist.

13. Verfahren nach Anspruch 1, **dadurch gekennzeichnet, dass**

   - eine Referenzfläche als Integral des gemessenen ersten Spannungsverlaufs berechnet wird
   - eine Fläche als Integral des gemessenen zweiten Spannungsverlaufs berechnet wird,
   - eine Differenzfläche als Differenz von Referenzfläche und Fläche berechnet wird, wobei die Differenzfläche den Unterschied zwischen dem gemessenen ersten und dem gemessen zweiten Spannungsverlauf darstellt,
   - eine Berechnung eines Fehlerflächenverhältnisses aus der Differenzfläche und der Referenzfläche gemäß der Formel

$$EAR_2 = \frac{\left|A_{diff_2}\right| * 100\%}{\left|A_{ref_2}\right|}$$

erfolgt, wobei $A_{ref_2}$ die Referenzfläche des gemessenen ersten Spannungsverlaufs ist und $A_{diff_2}$ die Differenzfläche ist, die den Unterschied zwischen dem gemessenen ersten und dem gemessen zweiten Spannungsverlauf darstellt,
- das Fehlerflächenverhältnis mit einem oberen und einem unteren Grenzwert verglichen wird und bei einem Überschreiten des oberen Grenzwertes oder bei einem Unterschreiten des unteren Grenzwertes ein spannungsabhängiger Fehler in dem elektrischen Wicklungssystem erkannt wird.

14. Verfahren nach Anspruch 4, **dadurch gekennzeichnet, dass**

- der Unterschied des gemessenen m. Spannungsverlaufs und des gemessenen m-1. Spannungsverlauf berechnet wird, wobei $2 \leq m \leq n,$
- n-1 obere Grenzwerte festgelegt werden und n-1 untere Grenzwerte festgelegt werden, wobei jeweils ein oberer und ein unterer Grenzwert jeweils einem der Unterschiede zugeordnet werden, wobei sich die oberen Grenzwerte aus dem Mittelwert der Unterschiede zuzüglich einer zugelassenen Abweichung und die unteren Grenzwerte abzüglich einer zugelassenen Abweichung berechnen,
- bei einem Unterschreiten einer der Unterschiede unter den zugehörigen unteren Grenzwert oder bei einem Überschreiten einer der Unterschiede über den zugehörigen oberen Grenzwert ein spannungsabhängiger Fehler in dem elektrischen Wicklungssystem erkannt wird.

15. Vorrichtung zur Erkennung von spannungsabhängigen Fehlern in einem elektrischen Wicklungssystem, umfassend zumindest ein Mittel zur Erzeugung eines Stoßspannungsimpulses, Anschlüsse für eine elektrische Verbindung der Vorrichtung mit dem elektrischen Wicklungssystem, ein Speichermittel, wobei das Speichermittel dazu ausgebildet ist, Messdaten der Spannungsverläufe zu empfangen, zu speichern und bereitzustellten, ein Auswertemittel, wobei das Auswertemittel dazu ausgebildet ist, die von dem Speichermittel bereitgestellten Messdaten der Spannungsverläufe zu vergleichen und mit den bereitgestellten Messdaten der Spannungsverläufe Hilfsgrößen zu berechnen, wobei die Vorrichtung dazu ausgebildet ist, ein Verfahren nach einem der vorherigen Ansprüche auszuführen.

**Claims**

1. Method for detecting voltage-dependent faults in an electrical winding system, comprising at least the following steps:

- outputting at least two surge voltage pulses to the electrical winding system, wherein each surge voltage pulse has a different peak value $U_t$,
- measuring voltage curves at the electrical winding system after outputting a respective surge voltage pulse, wherein the voltage curves each comprise a damped oscillation, each voltage curve being caused by one of the surge voltage pulses,
- storing the voltage curves,

**characterized in that**

- a first voltage curve, which is caused by a first of the surge voltage pulses, is used as a reference, for calculating a calculated second voltage curve, which is caused by a second of the surge voltage pulses,
- the calculated second voltage curve and the measured second voltage curve are compared with one another,
- in the case of a difference between the calculated and the measured second voltage curve above a limit value a voltage-dependent fault is detected in the electrical winding system.

2. Method according to claim 1, **characterized in that** the peak value of the second surge voltage pulse is formed by the peak value of the first surge voltage pulse plus a voltage increase.

3. Method according to claim 1 or 2, **characterized in that** the calculated second voltage curve is calculated from the first voltage curve multiplied by a scaling factor.

4. Method according to any one of claims 1 to 3, **characterized in that** n surge voltage pulses are output to the electrical winding system, wherein each of the m surge voltage pulses has a different peak value $U_{t_m}$.

5. Method according to claim 4, **characterized in that** the calculated $m^{th}$ voltage curve is calculated according to the formula

$$voltage\ curve_{m_{calculated}} = voltage\ curve_{m-1\ measured} * f$$

wherein *voltage curve*$_{m_{calculated}}$ is the calculated voltage curve of the $m^{th}$ surge voltage pulse,
wherein *voltage curve*$_{m-1_{measured}}$ is the measured voltage curve of the m-1$^{th}$ surge voltage pulse,
wherein f is the scaling factor
and wherein $2 \leq m \leq n$.

6. Method according to any one of claims 4 to 5, **characterized in that** the scaling factor is calculated as

$$f = \left. U_{t_m} \middle/ U_{t_{m-1}} \right.$$ , wherein $U_{t_m}$ is the peak value of the $m^{th}$

surge voltage pulse and $U_{t_{m-1}}$ is the peak value of the m-1$^{th}$ surge voltage pulse.

7. Method according to any one of claims 4 to 6, **characterized in that** for comparison of the calculated and measured $m^{th}$ voltage curve,

- a reference area is calculated as the integral of the calculated $m^{th}$ voltage curve,
an area is calculated as the integral of the measured $m^{th}$ voltage curve,
- a difference area is calculated as the difference between the reference area and area, wherein the difference area represents the difference between the calculated and the measured $m^{th}$ voltage curve.

8. Method according to claim 7, **characterized in that** a calculation of a fault area ratio from the difference area and the reference area is madea ccording to the formula,

$$EARm = \frac{|Adiff| * 100\%}{|Aref|}$$

wherein

$A_{ref}$ is the reference area,
$A_m$ is the area and
$A_{diff}$ is the difference area.

9. Method according to claim 8, **characterized in that** an expected fault area ratio is calculated, wherein the expected fault area ratio is subtracted from the calculated fault area ratio $EAR_m$ and a comparison is made between the difference between the expected fault area ratio and calculated fault area ratio with the limit value.

10. Method according to claim 8, **characterized in that** a fault area ratio is calculated for each of the m calculated and measured voltage curves.

11. Method according to claim 10, **characterized in that** the fault area ratios are normalized by means of a normalization factor.

12. Method according to claim 11, **characterized in that** the normalization factor is calculated according to the formula

$$\frac{U_{t_{m-1}}}{(U_{t_m} - U_{t_{m-1}}) * 100}$$ , wherein $U_{t_m}$ is the peak value of the $m^{th}$ pulse voltage pulse and $U_{t_{m-1}}$ is the peak value of the m-1$^{th}$ pulse voltage pulse.

13. Method according to claim 1, **characterized in that**

- a reference area is calculated as the integral of the measured first voltage curve,
- an area is calculated as an integral of the measured second voltage curve,

- a difference area is calculated as the difference between the reference area and area, wherein the difference area represents the difference between the measured first and the measured second voltage curve,
- a calculation of a fault area ratio is made from the difference area and the reference area according to the formula

$$EAR_2 = \frac{\left|A_{diff_2}\right| * 100\%}{\left|A_{ref_2}\right|}$$

wherein $A_{ref_2}$ is the reference area of the measured first voltage curve and $A_{diff_2}$ is the difference area representing the difference between the measured first and the measured second voltage curve,
- the fault area ratio is compared with an upper and a lower limit value and a voltage-dependent fault in the electrical winding system is recognized if the upper limit value is exceeded or if the value falls below the lower limit value.

14. Method according to claim 4, **characterized in that**

- the difference between the measured $m^{th}$ voltage curve and the measured $m-1^{th}$ voltage curve is calculated, wherein $2 \leq m \leq n,$
- n-1 upper limit values are determined and n-1 lower limit values are determined, wherein an upper and a lower limit value are each assigned to one of the differences, wherein the upper limit values are calculated from the mean value of the differences plus an allowed deviation and the lower limit values minus an allowed deviation,
- a voltage-dependent fault in the electrical winding system is recognized if one of the differences falls below the associated lower limit value or if one of the difference exceeds the associated upper limit value.

15. Device for detecting voltage-dependent faults in an electrical winding system, comprising at least one means for generating a surge voltage pulse, terminals for an electrical connection of the device to the electrical winding system, a memory means, wherein the memory means is configured to receive, store and provide measurement data of the voltage curves, an evaluation means, wherein the evaluation means is configured to compare the measurement data of the voltage curves provided by the memory means and to calculate auxiliary variables with the measurement data provided by the voltage curved, wherein the device is configured to perform a method according to any one of the preceding claims.

**Revendications**

1. Procédé de détection de défauts dépendant de la tension dans un système d'enroulement électrique, comprenant au moins les étapes suivantes :

- distribution d'au moins deux impulsions de tension de choc au système d'enroulement électrique, dans lequel chaque impulsion de tension de choc présente une autre valeur de crête $U_t$,
- mesure de courbes de tension au niveau du système d'enroulement électrique après la distribution respectivement d'une impulsion de tension de choc, dans lequel les courbes de tension comprennent respectivement une oscillation amortie, dans lequel chaque courbe de tension a été causée respectivement par une des impulsions de tension de choc,
- enregistrement des courbes de tension,

**caractérisé en ce que**

- une première courbe de tension, qui est causée par une première des impulsions de tension de choc, est utilisée comme référence afin de calculer une seconde courbe de tension calculée qui est causée par une seconde des impulsions de tension de choc,
- la seconde courbe de tension calculée et la seconde courbe de tension mesurée sont comparées l'une à l'autre,
- en cas de différence entre la seconde courbe de tension calculée et mesurée au-dessus d'une valeur limite, un défaut dépendant de la tension est détecté dans le système d'enroulement électrique.

2. Procédé selon la revendication 1, **caractérisé en ce que** la valeur de crête de la seconde impulsion de tension de choc est formée par la valeur de crête de la première impulsion de tension de choc plus une augmentation de tension.

**3.** Procédé selon la revendication 1 ou 2, **caractérisé en ce que** la seconde courbe de tension calculée est calculée à partir de la première courbe de tension multipliée par un facteur d'échelle.

**4.** Procédé selon l'une quelconque des revendications 1 à 3, **caractérisé en ce que** n impulsions de tension de choc sont délivrées en sortie au système d'enroulement électrique, dans lequel chacune des m impulsions de tension de choc présente une autre valeur de crête $U_{t_m}$.

**5.** Procédé selon la revendication 4, **caractérisé en ce que** la m$^{\text{ième}}$ courbe de tension calculée est calculée selon la formule

$$courbe\ de\ tension_{m_{calculée}} = courbe\ de\ tension_{m-1_{mesurée}} * f$$

dans lequel *courbe de tension$_{mcalculée}$* est la courbe de tension calculée de la m$^{\text{ième}}$ impulsion de tension de choc, dans lequel *courbe de tension$_{m-1mesurée}$* est la courbe de tension mesurée de la m-1$^{\text{ième}}$ impulsion de tension de choc, dans lequel *f* est le facteur d'échelle et dans lequel *2≤m≤n.*

**6.** Procédé selon l'une quelconque des revendications 4 à 5, **caractérisé en ce que** le facteur d'échelle est calculé comme $f = {U_{t_m}} \big/ {U_{t_{m-1}}}$ dans lequel $U_{tm}$ est la valeur de crête de la même impulsion de tension de choc et $U_{tm-1}$ est la valeur de crête de la m$^{\text{ième}}$ impulsion de tension de choc.

**7.** Procédé selon l'une quelconque des revendications 4 à 6, **caractérisé en ce que** pour la comparaison de la m$^{\text{ième}}$ courbe de tension calculée et mesurée

- une surface de référence est calculée comme intégrale de la m$^{\text{ième}}$ courbe de tension calculée
- une surface est calculée comme intégrale de la m$^{\text{ième}}$ courbe de tension,
- une surface de différence est calculée comme différence entre la surface de référence et la surface, dans lequel la surface de différence représente la différence entre la m$^{\text{ième}}$ courbe de tension calculée et mesurée.

**8.** Procédé selon la revendication 7, **caractérisé en ce qu'**un calcul d'un rapport de surface de défaut est effectué à partir de la surface de différence et de la surface de référence selon la formule

$$EAR_m = \frac{\left|A_{diff}\right| * 100\%}{\left|A_{ref}\right|}$$

dans lequel

$A_{ref}$ est la surface de référence,
$A_m$ est la surface et
$A_{diff}$ est la surface de différence.

**9.** Procédé selon la revendication 8, **caractérisé en ce qu'**un rapport de surface de défaut attendu est calculé, dans lequel le rapport de surface de défaut attendu est soustrait du rapport de surface de défaut calculé $EAR_m$, et une comparaison de la différence entre le rapport de surface de défaut attendu et le rapport de surface de défaut calculé avec la valeur limite est effectuée.

**10.** Procédé selon la revendication 8, **caractérisé en ce qu'**un rapport de surface de défaut est calculé pour chacune des m courbes de tension calculées et mesurées.

**11.** Procédé selon la revendication 10, **caractérisé en ce que** les rapports de surface de défaut sont normalisés au moyen d'un facteur de normalisation.

**12.** Procédé selon la revendication 11, **caractérisé en ce que** le facteur de normalisation est calculé selon la formule

$\dfrac{U_{t_{m-1}}}{(U_{t_m}-U_{t_{m-1}})*100}$, dans lequel $U_{t_m}$ est la valeur de crête de la m$^{\text{ième}}$ impulsion de tension de choc et $U_{tm\text{-}1}$ la valeur de crête de la m-1$^{\text{ième}}$ impulsion de tension de choc.

13. Procédé selon la revendication 1, **caractérisé en ce que**

   - une surface de référence est calculée comme intégrale de la première courbe de tension mesurée
   - une surface est calculée comme intégrale de la seconde courbe de tension mesurée,
   - une surface de différence est calculée comme différence entre la surface de référence et la surface, dans lequel la surface de différence représente la différence entre la première et la seconde courbe de surface mesurées,
   - un calcul d'un rapport de surface de défaut est effectué à partir de la surface de différence et de la surface de référence selon la formule

$$EAR_2 = \frac{\left|A_{diff_2}\right| * 100\%}{\left|A_{ref_2}\right|}$$

   dans lequel $A_{ref_2}$ est la surface de référence de la première courbe de tension mesuré et $A_{diff_2}$ est la surface de différence qui représente la différence entre la première et la seconde courbe de tension mesurées,
   - le rapport de surface de défaut est comparé avec une valeur limite supérieure et inférieure et si la valeur limite supérieure est dépassée ou si la valeur limite inférieure n'est pas atteinte, un défaut dépendant de la tension est détecté dans le système d'enroulement électrique.

14. Procédé selon la revendication 4, **caractérisé en ce que**

   - la différence entre la m$^{\text{ième}}$ courbe de tension mesurée et de la m-1$^{\text{ième}}$ courbe de tension mesurée est calculée, dans lequel $2 \leq m \leq n,$
   - n-1 valeurs limites supérieures sont fixées et n-1 valeurs limites inférieures sont fixées, dans lequel respectivement une valeur limite supérieure et inférieure sont associées respectivement à l'une des différences, dans lequel les valeurs limites supérieures se calculent à partir de la valeur médiane des différences plus un écart autorisé, et les valeurs limites inférieures se calculent moins un écart autorisé,
   - un défaut dépendant de la tension est détecté dans le système d'enroulement électrique si l'une des différences n'atteint pas la valeur limite inférieure associée ou si l'une des différences dépasse la valeur limite supérieure associée.

15. Dispositif de détection de défauts dépendant de la tension dans un système d'enroulement électrique, comprenant au moins un moyen de génération d'une impulsion de tension de choc, des raccords pour une liaison électrique du dispositif avec le système d'enroulement électrique, un moyen d'enregistrement, dans lequel le moyen d'enregistrement est configuré afin de recevoir, d'enregistrer et de fournir des données de mesure des courbes de tension, un moyen d'évaluation, dans lequel le moyen d'évaluation est configuré afin de comparer les données de mesure des courbes de tension fournies par le moyen d'enregistrement et de calculer des grandeurs auxiliaires avec les données de mesure des courbes de tension fournies, dans lequel le dispositif est configuré afin de réaliser un procédé selon l'une quelconque des revendications précédentes.

Fig. 1

```
┌─────────────────────────────────────────┐
│          Start der Fehlererkennung        │
└─────────────────────────────────────────┘
                     │
                     ▼
┌─────────────────────────────────────────┐
│    Einstellen des Spitzenwertes U_t des   │
│            Stoßspannungsimpulses          │
└─────────────────────────────────────────┘
                     │
                     ▼
┌─────────────────────────────────────────┐
│    Abgabe eines Stoßspannungsimpulses an das │
│         elektrische Wicklungssystem       │
└─────────────────────────────────────────┘
                     │
                     ▼
┌─────────────────────────────────────────┐
│  Messung des Spannungsverlaufes als Antwort auf den │
│            Stoßspannungsimpuls            │
└─────────────────────────────────────────┘
                     │
                     ▼
┌─────────────────────────────────────────┐
│       Speicherung des Spannungsverlaufes  │
└─────────────────────────────────────────┘
                     │
                     ▼
┌─────────────────────────────────────────┐
│   Nutzen des Spannungsverlaufs als Referenz zur │
│ Berechnung eines berechneten Spannungsverlaufes │
│        des nächsten Stoßspannungsimpulses │
└─────────────────────────────────────────┘
                     │
                     ▼
              Mindestens 2
           Spannungsverläufe          nein ──┐
            gespeichert?                      │
                     │ ja                      │
                     ▼                         │
┌─────────────────────────────────────────┐   │
│ Vergleich des berechneten Spannungsverlaufes mit │   │
│       dem gemessenen Spannungsverlauf     │   │
└─────────────────────────────────────────┘   │
                     │                         │
                     ▼                         │
           Unterschied oberhalb       nein ──┤
              Grenzwert?                       │
                     │ ja
                     ▼
┌─────────────────────────────────────────┐
│  Erkennung einer spannungsabhängigen Fehlers │
└─────────────────────────────────────────┘
                     │
                     ▼
┌─────────────────────────────────────────┐
│        Beenden der Fehlererkennung        │
└─────────────────────────────────────────┘
```

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2007108058 A